# EUROPEAN PATENT SPECIFICATION

(11) **EP 2 765 431 B1**
(45) Date of publication and mention of the grant of the patent: **25.05.2016**
(21) Application number: 13154816.6
(22) Date of filing: 11.02.2013
(51) Int. Cl.: G01R 31/28

(54) **Carrier for electronic components**
Träger für elektronische Komponenten
Support de composants électroniques

(43) Date of publication of application: 13.08.2014
(73) Proprietor: Rasco GmbH, 83059 Kolbermoor (DE)
(72) Inventor: Waldauf, Alexander, 6306 Söll (AT)
(74) Representative: Grünecker Patent- und Rechtsanwälte PartG mbB

(56) References cited:
- EP-A2- 2 290 375
- JP-A- H0 373 551
- US-A1- 2006 154 386
- US-A1- 2007 131 733
- US-A1- 2009 104 014
- US-A1- 2010 206 768

## Description

### Field of the Invention

The present invention relates to a carrier for holding, transferring and aligning batches of individual electronic components (semiconductor devices).

### Background of the Invention

Electronic components, for example IC chips or Ball Grid Arrays, need to be tested after having been manufactured in a mass production process. The electronic components are tested as strip-shaped composites or as individual components usually grouped in batches. Testing of strip-shaped composites is not considered in the present invention. The batches are moved by some transfer element into a test position. At the test position the electrical terminals of the electronic components of the batch are contacted with some testing head of a testing device. Predetermined tests for particular electronic characteristics of the electronic components of the batch are performed by means of the testing head.

In order to simultaneously test a plurality of electronic components of a batch a plurality of electrical contacts have to be provided in the testing head and highly accurate alignment of the electrical contacts of the testing header and the electrical terminals of the individual electronic components of the batch under investigation has to be ensured. In the art, it is known to accommodate individual electronic components in individual receiving pockets of a carrier and transfer the carrier to a testing head where electrical contact is made with the individual electronic components for testing purposes. The carrier, for example, comprises spring elements and stop elements for securing the individual electronic components in the individual receiving pockets (US 7 258 703 and US 2010/0206768 A1).

In JP H03 73551 A a carrier with an upper clamping plate moveable with respect to a lower substrate an operated by a lever to clamp semiconductor chips by means of spring mechanisms is described. In EP 2 290 375 A2 a carrier for aligning electronic components comprising receptacles adapted to receive the electronic components, a first plate with abutting sections and a second plate with abutting sections, wherein the first and second plates are slidably relative to each other is described. In US 2009/104014 A a carrier comprising a positioning plate with openings and holding pieces formed integrally from the positioning plate is described.

However, the known conventional securing mechanisms suffer from complicated and expensive constructions. In particular, relatively large spring elements are needed in the art for providing the clamping force for each electronic component. Such spring elements heavily suffer from ageing and restrict the density of receiving pockets and, thus, the number of the individual electronic components that are to be tested. Moreover, the reliability of the fastening of the individual electronic components that are to be transferred and tested should be improved. Therefore, it is an object of the present invention to provide means for holding, transferring and aligning batches of individual electronic components (semiconductor devices), particularly, for testing purposes that overcome the abovementioned problems.

### Description of the Invention

The above-mentioned object is addressed by the carrier for carrying a plurality of electronic components according to claim 1.

This carrier comprises a base plate comprising a plurality of seats or openings each configured to accommodate one of the plurality of electronic components; and a first actuator moveable in a first direction with respect to the base plate for securing more than one of the plurality of electronic components in the seats or openings in a clamped state of the carrier, wherein the base plate comprises an elongated element formed on the base plate and comprising dead stops for receiving edges of the electronic components in the clamped state and the first actuator comprises a plurality of clamping elements arranged along a straight line and configured for securing the electronic components in the clamped state.
which the electronic components are secured in the clamped state of the carrier. Moreover, the seats may be recessed in the first plate or may protrude from the first plate. The first plate may have one or more elements mounted thereon or formed integrally therewith and the seats may be parts of the element(s) mounted on the first plate. The electronic components can be of rectangular shape and, thus, the seats and openings can also be of rectangular shape.

In an opened state of the carrier the electronic components can be inserted. For securing the electronic components the first actuator is moved thereby clamping the electronic components in a clamped (secured, locked) state of the carrier. The first actuator represents a mechanical means, for example, a structured plate or a bar, that exerts a mechanical force on the clamped electronic components. In the art, for each of the electronic components one or more actuators in the form of springs are needed (see description above). In the present invention, by one actuator that is not made of a spring a plurality of electronic components are secured in the clamped state of the carrier. A subset or all of the electronic components may be secured by operation of the first actuator. If not all of the electronic components are secured by the first actuator one or more additional actuators are provided for securing the remaining electronic components that are not secured by the first actuator. For example, the first actuator may be provided for securing half of the number of the electronic components handled by means of the carrier and a second actuator is provided for securing the other half. One actuator may be provided for securing one or two rows of electronic components and one or more other actuators may be provided for securing the other rows of the batch of electronic components.

Since there is no longer a need for providing one or more springs as actuators for each individual electronic component, the density of electronic components on the carrier can be increased. Moreover, the single mechanical actuator for securing a number of electronic components shows an increased durability as compared to the above-described spring actuators of the art. Safe transfer to and alignment with a testing header of a testing device can be guaranteed. Moreover, the carrier can be produced at relatively low costs due to the relatively simple construction.

The first actuator can be opened by a single opener for moving the actuator and the carrier from the clamped state into the opened state. Different from the art there is no need for an individual opener provided for each of the plurality of electronic components. In fact, there may be more than one actuator each being operated by an individual single opener in the inventive carrier. However, the number of actuators and openers of the inventive carrier is less than the number of electronic components to be handled by means of the carrier.

The first actuator may be configured to contact the electronic components by elastic means. The elasticity of the deformable elastic means allows for providing some tolerances with respect to the actual dimensions of the electronic components and possible contaminations of the electronic components. The elastic means may be realized in the form of polymeric means like polymeric lips or knobs.

The first actuator may comprise a linear guiding element with a longitudinal axis and the clamping elements can be formed as wedges, in particular, in the shape of right-angled triangles, on both sides of the linear guiding element. One edge of each of the wedges contacts a corner of one of the electronic components for securing it safely to a corresponding dead stop of the elongated element. The clamping elements can be grouped in pairs and, in this case, one clamping element of a pair of clamping elements is arranged on one side of a linear guiding element and the other clamping element of the pair of clamping elements is arranged on the other side of the linear guiding element symmetrically to the linear guiding element. In this embodiment, the electronic components can be arranged in rows parallel to the longitudinal axis of the linear guiding element and in the clamped state one clamping element of each pair of clamping elements can be operable to exert the mechanical force on an electronic component of one row and, in this case, the other clamping element of each pair of clamping elements is operable to exert the mechanical force on another electronic component of another row (neighboured and arranged parallel to the first mentioned row).

In the opened state of the carrier according to this embodiment the electronic components can be inserted at or close to the dead stops of the elongated element of the first plate and without contact with the edges of the wedges. The opened state is achieved by pushing the first actuator (linear guiding element) by means of a single opener acting on some opening element of the actuator (the opening element may be part of or attached to the guiding element). The linear guiding element is movable to exert a mechanical force on the corner of the rectangular electronic component when accommodated in a pocket by the hypotenuse edge of the wedge (triangle).

According to an example, a wedge shaped clamping element or a pair of wedge shaped clamping elements arranged symmetrically on both sides of a linear guiding element that connects pairs of clamping elements along a main longitudinal axis of the rectangular clamping plate is directly connected to a spring element. The spring element can be formed as a (pre-loaded) leaf spring. The spring, in this example, is provided in order to compensate for non-uniformity of the electronic components, i.e. it provides for some tolerance and fine adjustment of the mechanical force exerted on the electronic component. It is important to note that the main clamping force is provided by the actuator and clamping elements and that the springs are just provided for compensation purposes. These compensation purposes can, alternatively, by provided by making the clamping elements of some sufficiently resilient (deformable) material allowing for some deformation of the clamping elements in the clamped state.

Moreover, it may be preferable to provide for each of the clamping elements first and second stops formed on the linear guiding element and arranged for restricting movement of the clamping elements along the longitudinal axis of the linear guiding element. The first stop restricts the movement of the clamping elements during transition of the carrier from the opened state to the clamped state and the second stop restricts the movement of the clamping elements during transition of the carrier from the clamped state to the opened state.

According to another example, the carrier may further comprise a second actuator comprising another linear guiding element and the clamping elements formed on both sides of the other linear guiding element, in particular, in the form of wedges. The first and second actuators are arranged parallel to each other and each of the actuators can be opened by a corresponding opener separately from each other. Securement and release or insertion of the electronic components can, thus, be carried out for different pair of rows of electronic components separately, for example.

In all of the above-described examples, the first actuator is movable for securing or releasing the electronic components. One or more second actuators may be additionally provided that are operable subsequently in parallel to operation of the first actuator. The directions of movements of the actuators may be parallel to each other. Thereby, for example, individual rows of electronic components can be dealt with separately. However, it might also be considered appropriate to provide a second actuator that is movable in a second direction different from the first direction of movement of the first actuator (for example, perpendicular to the first direction) in order to further secure the electronic components by exerting mechanical forces in a direction different from the one of the forces exerted by the first actuator. For example, by the first actuator the electronic components are pressed against ones of the edges of the opening or seats of the first plate accommodating the electronic components and by the second actuator the electronic components are pressed against other ones of the edges of the opening or seats of the first plate accommodating the electronic components. The first and second actuators can be arranged in different planes on the same side or on different sides of the first plate.

Further features and advantages of the present invention will be described in the following with reference to the figures, which illustrate only examples of embodiments of the present invention. The illustrated and described features may be suitably combined with each other.
Figures 1 a and 1 b show a loading station for loading a carrier and an opener.
Figures 2a, 2b and 2c show, respectively, an exploded view and plan views of an example of a carrier not being part of the invention wherein the carrier comprises pockets for accommodating electronic components and a clamping plate for securing the electronic components.
Figures 2d to 2f show a carrier similar to the one shown in Figures 2a to 2c but comprising an additional clamping plate.
Figures 3a, 3b and 3c illustrate an example of an inventive carrier wherein clamping elements in form of wedge elements are provided for securing electronic components.
Figures 4a to 4d illustrate an example of a carrier not being part of the invention wherein electronic components are secured by means of bands.
Figures 5a to 5c illustrate another example of a carrier not being part of the invention wherein electronic components are secured by means of bands.
Figure 6 illustrates in a detailed view securing of an electronic component in the examples shown in Figures 4a to 5c.

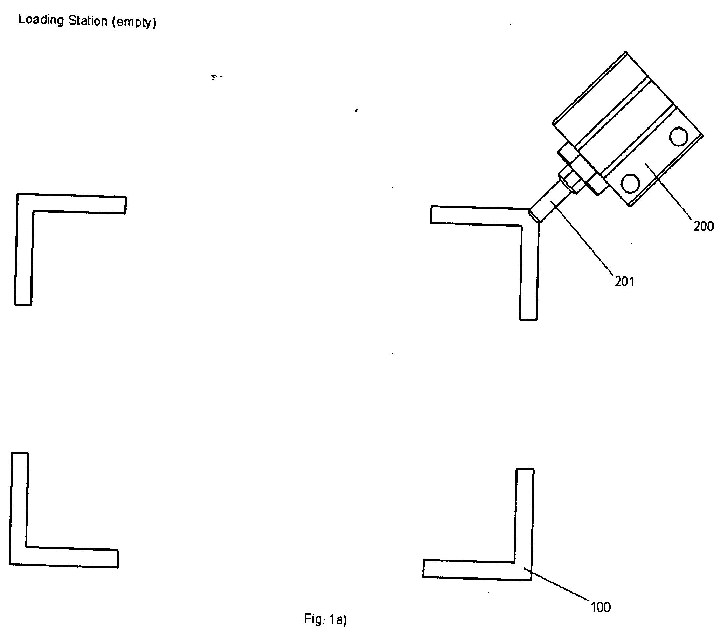

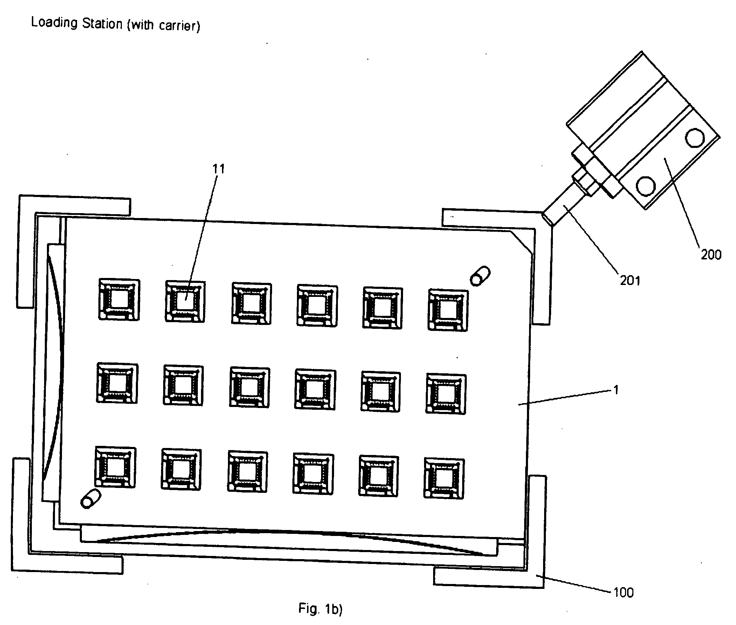

Figures 1a and 1b show a loading station 100 for loading a carrier 1. Electronic components 11, for example, IC chips, that are to be tested by some testing device to which they can be transferred by means of the shown example of the inventive carrier 1, are to be secured on the carrier 1. The carrier 1 can be in an opened state wherein the electronic components are to be inserted or are inserted but not secured or in a clamped (locked, secured) state wherein the electronic components are inserted and secured. Opening and closing of the carrier 1 is caused by an opener 200. The opener 200 may comprise an actuating bolt 201 operating on a bevelled corner of the carrier 1.

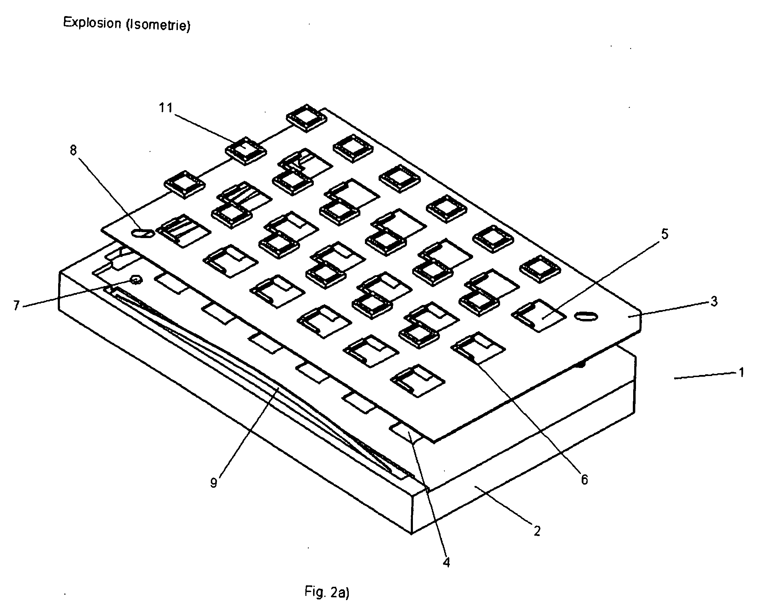

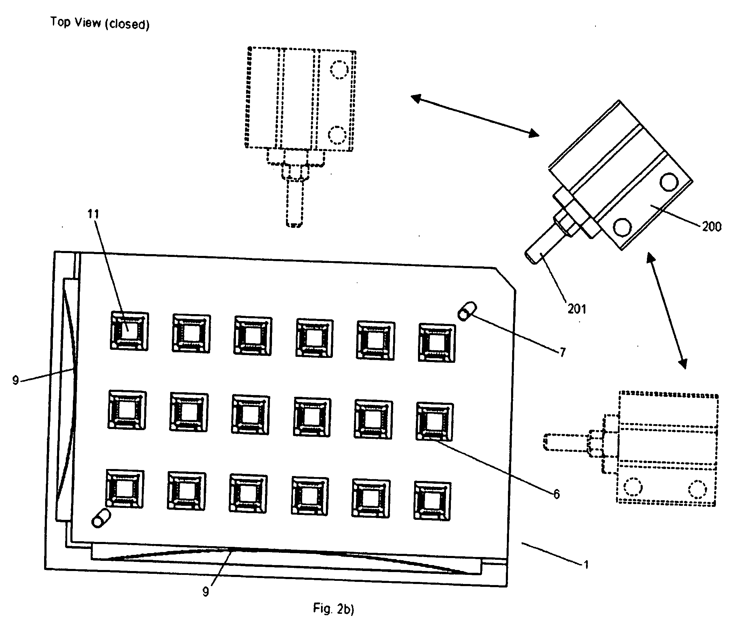

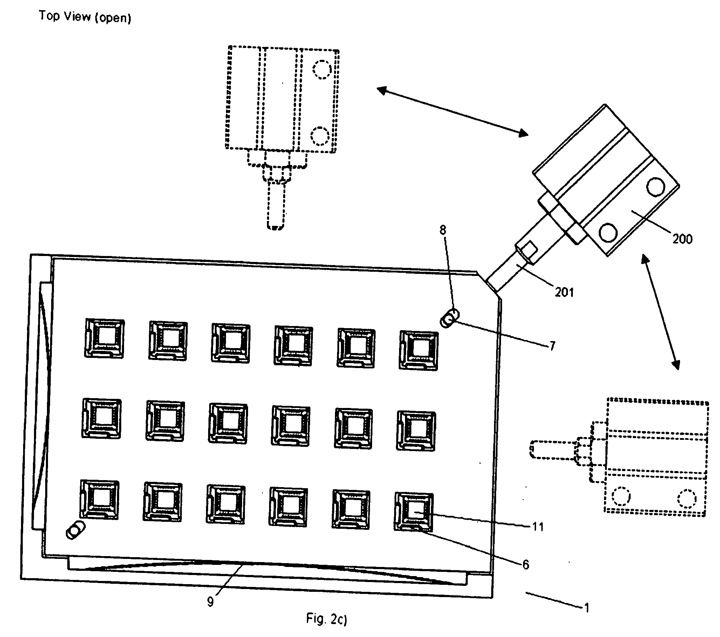

In Figure 2a an exploded view of an example of a (clamping) carrier 1 for electronic components 11 that is not part of the present invention is shown. In Figure 2b a clamped state of the carrier 1 shown in Figure 2a is illustrated and in Figure 2c an opened state of the carrier 1 shown in Figure 2a is illustrated. The carrier 1 comprises a base plate 2 and a clamping plate (actuator) 3. The clamping plate 3 is moveable with respect to the base plate 2. The base plate 2 comprises a plurality of pockets 4. The pockets 4 of the base plate 2 can have a substantially rectangular form and can be structured pockets 4 that comprise plateau or mesa regions on which the electronic components can rest.The clamping plate 3 comprises a plurality of openings 5 corresponding to the pockets 4 of the base plate 2. For each of the pockets 5 elastic means 6 are provided for contacting the electronic components 11. The elastic means 6 may be provided in form of two polymeric lips arranged at edges of the openings 5. The elastic means 6 are provided for accounting for tolerances.

Transition of the carrier 1 from an opened stated to a clamped state and vice versa is achieved by relative movement of the clamping plate 3 with respect to the base plate 2. This movement, in the shown example, is guided by guiding pins 7 formed in the base plate 2 and corresponding long holes 8 formed in the clamping plate 3. In the shown example, diagonal movement of the rectangular clamping plate 3 with respect to the rectangular base plate 2 can be caused by the opener 200 shown in Figures 1a and 1b. In this and all other examples, the clamped state (shown in Figure 2a) can be secured by a leaf spring 9 or any other means known in the art and at least provided at one edge of the base plate 2. In the clamped state the electronic components 11 are secured between the elastic means 6 of the openings 5 of the clamping plate 3 and edges of the pockets 4 of the base plate 2 that function as dead stops in the clamped state. By pushing the clamped plate 3 at the bevelled corner of the carrier 1 by the opener 200 against leaf spring 9, the carrier 1 is transitioned from the clamped state (Figure 2b) to the opened state (Figure 2c) due to the corresponding movement of the clamping plate 2 with respect to the base plate 2 guided by the guiding pins 7 and long holes 8. In the opened state the elastic means 6 no longer contact the electronic components 11 and the electronic components 11 can be removed from the carrier 1.

As illustrated in Figures 2a to 2c only one single opener 200 is needed for operating the single actuator realized in form of the clamping plate 3 securing the electronic components in the clamped state. The opener 200, in principle, can be arranged to act along an arbitrarily preselected line of force, for example, in a diagonal or longitudinal direction of the carrier 1. No individual springs are needed as individual actuators exerting forces on individual electronic components and to be operated by individual openers as it is the case in the art.

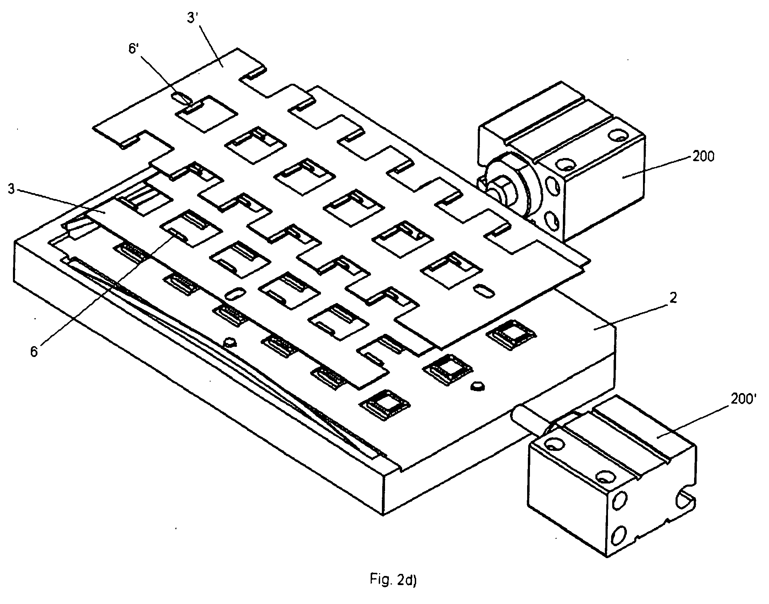

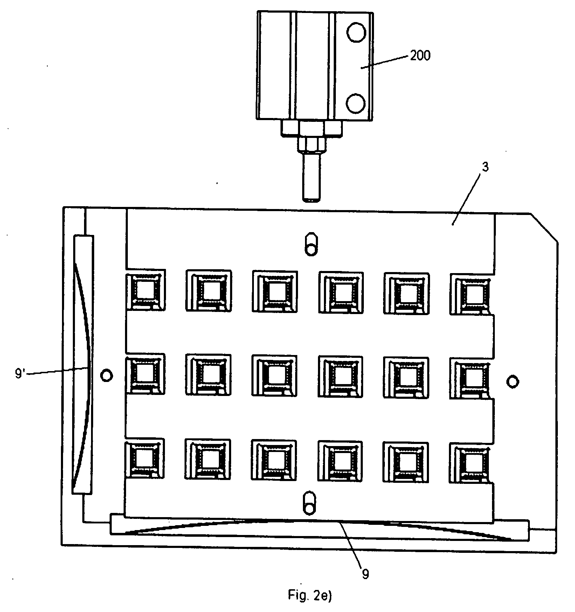

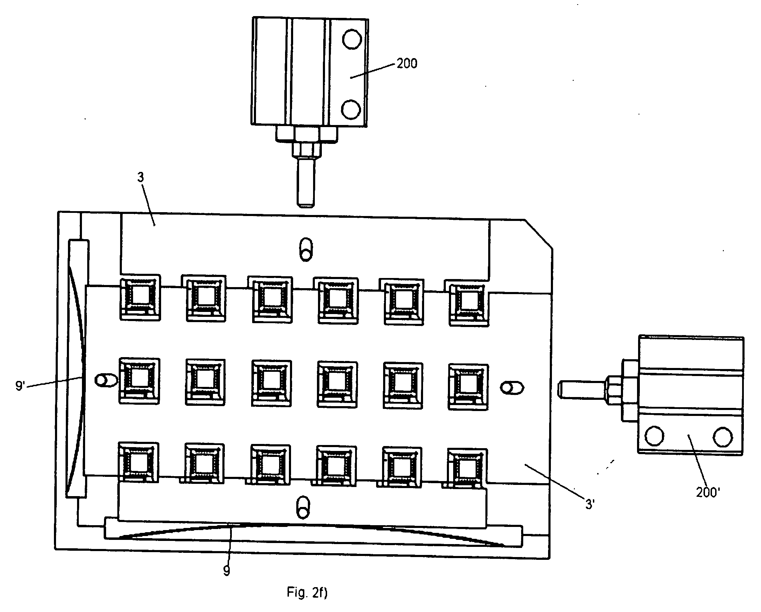

In Figure 2d a carrier similar to the one shown in Figures 2a to 2c is illustrated. In this example, however, another clamping plate 3' is provided in addition to clamping plate 3. The two clamping plates 3 and 3' stacked over each other are moveable with respect to the base plate 2 for transition between the opened and clamped states. Both plates comprise opening and elastic means 6 and 6', respectively, provided at edges of the openings. Moreover, they are moveable with respect to each other and in different directions with respect to the first plate. In the shown example, the clamping plate 3 is moveable in the longitudinal direction with respect to the base plate 2 and the clamping layer 3' is moveable in the latitudinal direction with respect to the base plate 2. In the clamped state, the electronic components 11 are secured by both clamping plates 3 and 3'. The clamping plate 3 may be operated by a first opener 200 and the clamping plate 3' may be operated by a second opener 200' different from the first one. Figures 2e and 2f show top views of the carrier with the first clamping plate 3 and both the first and second clamping plates 3 and 3', respectively. The first and second clamping plates 3 and 3' are secured to respective leaf springs 9 and 9'.

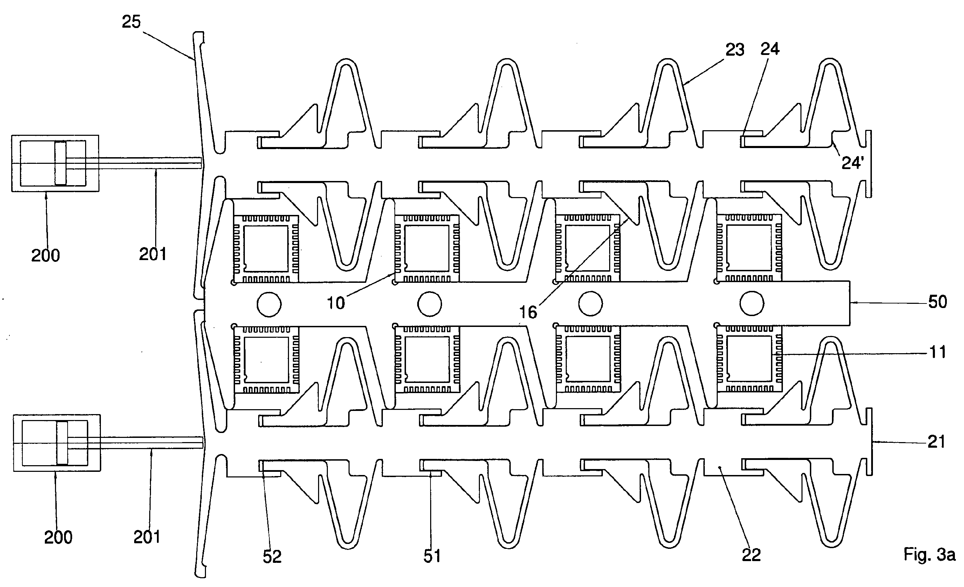

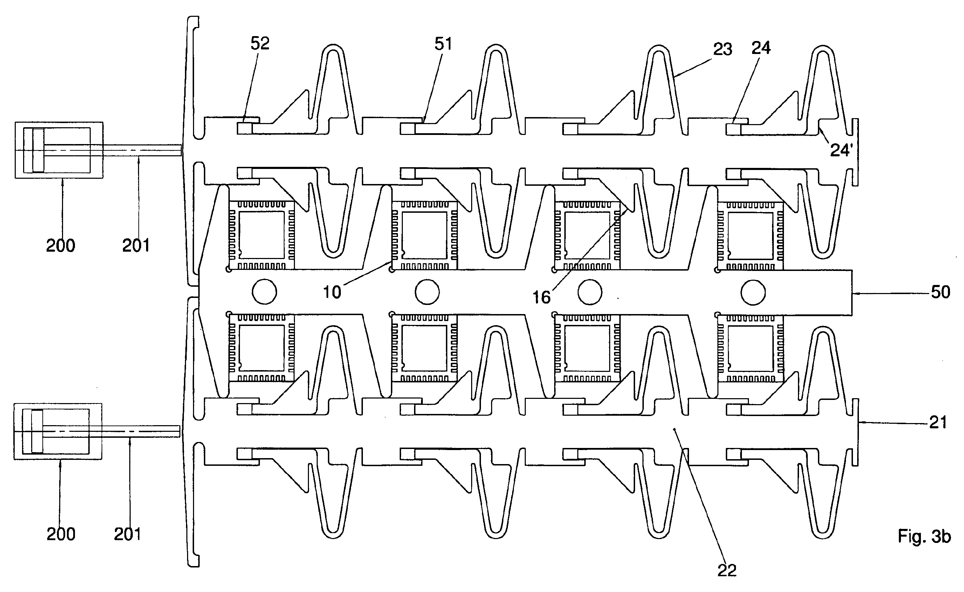

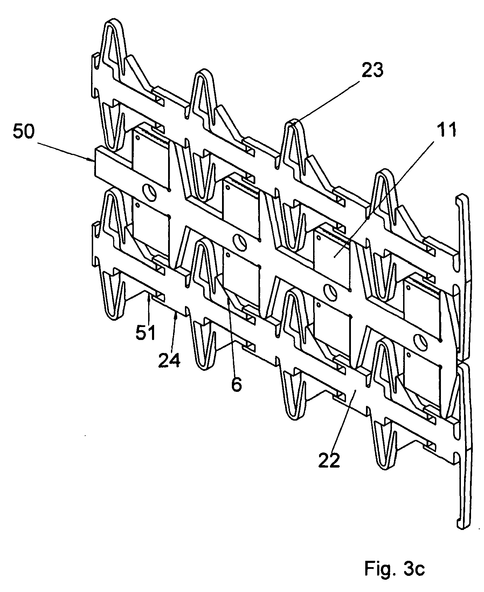

An embodiment of the present invention is illustrated in Figures 3a, 3b and 3c.
The shown embodiment comprises a base plate or cover plate comprising an element (securing element) 50 with dead stops 10 formed as integral parts of the same or mounted thereon. The dead stops 10 are provided for securing electronic components 11 in the clamped state.

The actuators 21 comprise clamping elements 16 arranged along linear guiding elements 22 that extend parallel to the rows of electronic components 11, spring elements 23 and stoppers 24. Moreover, an opening element 25 is provided at the end of a linear guiding element 22 that may or may not be integrally formed with the linear guiding element 22. The opening element is operated by opener 200. The linear guiding elements 22 and the clamping elements 16 may be integrally formed. Particularly, the clamping elements 16 and the linear guiding elements 22 may be etched from a stainless steel plate, for example, from stainless steel sheet with a thickness of about 0.2 mm. It is to be understood that the number of actuators 21 for the carrier 1, in principle, can be chosen arbitrarily.

In the opened state shown in Figure 3a the electronic components 11 are inserted in the carrier loosely contacting the dead stops 10 of the element 50 that is formed on a base plate. In the opened state of the carrier the electronic components 11 are not contacted by the clamping elements 16.The opening elements 25 may be realized by preloaded spring and the opened state is maintained by the opener 200 acting against the spring force of the preloaded springs. The opener 200 may mechanically act on the opening element 25 by means of an actuating bolt 201.

When the opener 200 moves the actuating bolt 201 away from the opening element 25 transition to the clamped state (Figure 3b) of the carrier is achieved. In the clamped state the electronic components 11 are secured to the dead stops 10 by the clamping elements 16. By actuating one actuator 21 by one opener 200 a number of electronic components 11 arranged in two rows (operated by pairs of clamping elements 16 arranged on both sides of the respective linear guiding element 22) are secured or released. The wedge-type clamping elements 16 have guiding extensions 51 that, in the opened state of the carrier (Figure 3a), are inserted in respective guiding slots 52 restricted by stoppers 24. In the clamped state (Figure 3b) the guiding extensions 51 are moved outwardly leaving some more space in the respective guiding slots 52 and restricted, if need by, by complementary stoppers 24'. The complementary stoppers 24' are provided for preventing damages in the clamped state that otherwise could be caused by contaminated electronic components 11 or individual electronic components 11 of inappropriate dimensions.

The springs 23 are only provided to account for tolerances. They might be omitted, if the clamping elements 16 are formed of a material that allows for some deformation sufficient to compensate for tolerances, for example, of the sizes of possible contaminated electronic components 11 and/or inaccuracies of the movement and constructional details or wear of the actuator 21 (linear guiding element 22) and/or the clamping elements 16.

A close-up of the embodiment illustrated in Figures 3a and 3b is shown in Figure 3c. Particularly, it can be seen from Figure 3c that the thicknesses of the linear guiding elements 22, wedge-type clamping elements 16, stoppers 24 and 25' and spring elements 23 are the same in the shown example. The electronic components 11 are at most as thick as the elements 22, 6, 24, 23 and the securing element 50 in order to guarantee secure fastening of the electronic components 11.

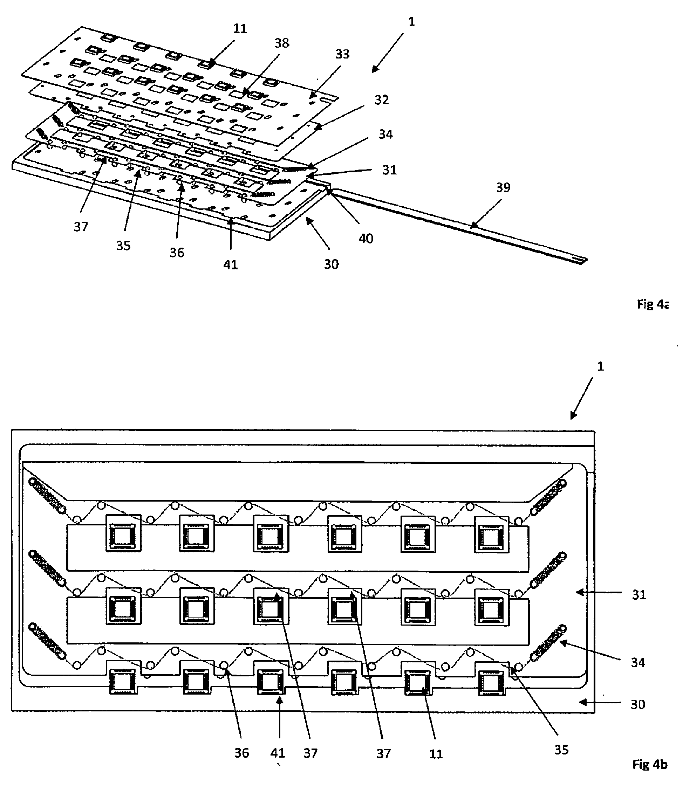

Figure 4a shows an exploded view of another example not being part of the invention. The carrier 1 shown in Figure 4a comprises a base plate 30 and a clamping plate 31 as an actuator and a cover plate that in the shown example comprise a lower part 32 and an upper part 33. In an opened state of the carrier 1, electronic components 11 can be introduced.

The clamping plate 31 comprises springs 34, bands (cords) 35, deflection elements 36, for example, deflection balls, and openings 37 for accommodating electronic components 11. It may be preferred to provide both the upper and the lower side of the clamping plate 31 or only of these sides with corresponding springs 34, bands (cords) 35 and deflection elements 36. The cover plate comprises openings 38 corresponding to the openings 37 of the clamping plate 31. According to another example, pockets are provided in the base plate 30 and, in this case, the clamping plate 31 comprises openings corresponding to the pockets of the base plate 30. The clamping plate 31 is moveable with respect to the base plate 30.

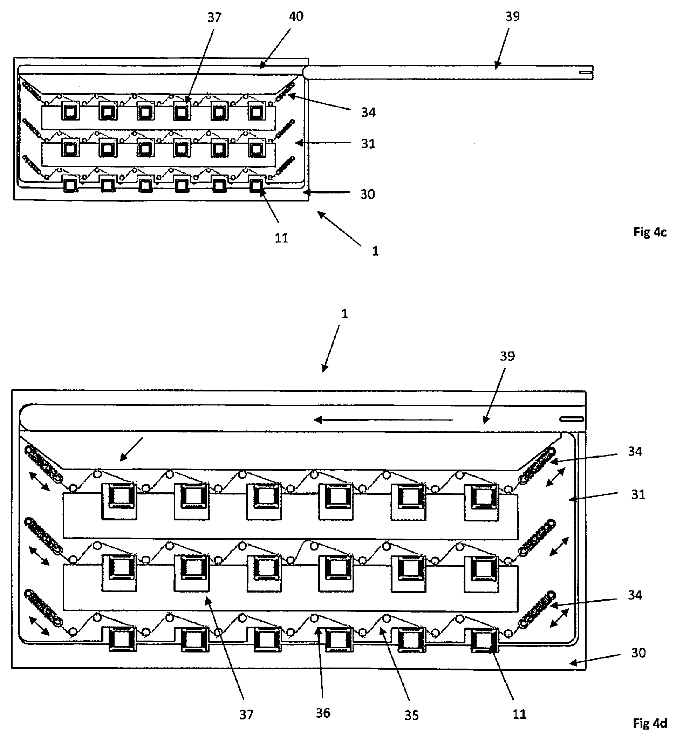

Also shown in Figure 4a a movable locking bar 39 is used for bringing the carrier 1 into a clamped state wherein the inserted electronic components 11 are secured. In the opened state the movable locking bar 39 is removed from the bearing 40 provided in the base plate 30. As shown in Figure 4b electronic components 11 are inserted in the openings 37 in an opened state of the carrier 1. In the opened state (Figures 4b and 4c) the springs 34 cause some pre-tensioning of the bands 35. After the electronic components 11 are inserted in the openings 37 the locking bar 39 is used for bringing the carrier 1 into a clamped state. The locking bar is moved into the bearing 40. Thereby, the clamping plate 31 is moved toward the lower edge of the base plate 30. The movement of the clamping plate 31 is, for example, guided by guiding pins moving along corresponding long holes formed in the base plate 30. The carrier 1 shown in Figures 4a and 4d comprises cut-outs 41 at the lower edge for accepting the lower edges of the electronic components 11 of the lowest row of electronic components 11 to be carried by the carrier 1. In the clamped state the electronic components 11 of the lowest row of electronic components 11 can be secured by means of the cut-outs 41 only or additionally by respective dead stops provided in the lower part 32 and/or upper part 33 of the cover plate (confer Figure 4a).

During movement of the clamping plate 31 for transitioning the carrier 1 from the opened state to the clamped state the electronic components 11 have to be fixed with respect to the bottom plate 30 and/or lower part 32 and/or upper part 33 of the cover plate in order to exert a mechanical force on the electronic components 11 by means of the clamping plate 31. In other words, the clamping plate 31 is moved with respect to the electronic components 11. The electronic components 11 can be fixed during the movement by (edges) of pockets (not shown in Figures 4a to 4d) provided in the base plate 30 and/or edges of openings provided in the cover sheet. The electronic components 11 are thick enough that different stacked plates can interact with the electronic components 11. For example, the electronic components 11 have thicknesses of some 1 mm and the plates of some 0.2 mm.

Figure 4d shows the carrier 1 in the clamped state wherein the locking bar 34 is completely inserted into the bearing 40 of the base plate 30. Edges of the openings 37 of the clamping plate 31 and/or the bands 35 exert mechanical forces on the respective upper right corners of the electronic components 11. The electronic components 11 are secured by the clamping plate 31 in interaction with corresponding dead stops provided in the lower part 32 and/or upper part 33 of the cover plate or corresponding pockets formed in the base plate 30, for example. The springs 34 are loaded and thereby exert a counterforce on the bands. The interaction of the springs 34 and bands 35 allow for fine adjustment and compensation for tolerances.

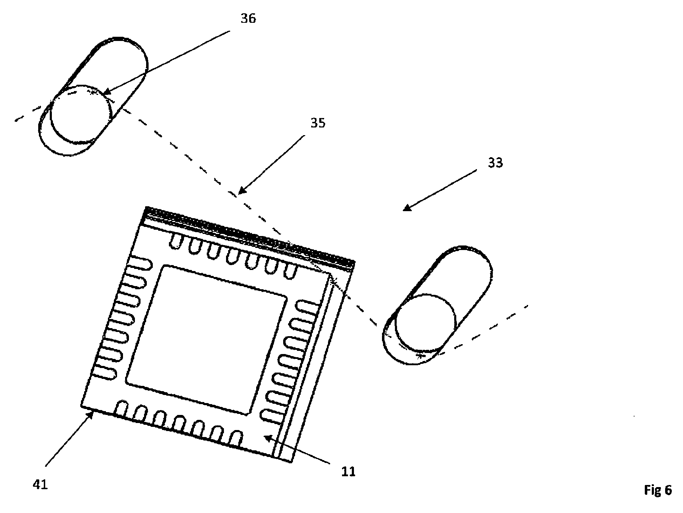

The deflection elements 36 of the clamping plate 31 are arranged such that due to the deflection caused by them the bands 35 are tightened and the tightened bands 35 help keeping the electronic components 11 in place. This effect, according to a particular example, is shown in detail in Figure 6. An electronic component 11 is secured by band 35 guided by deflection elements 36 and an L-shaped dead stop 41, for example, formed by the edge of a pocket or opening provided in the base plate 30 and/or cover plate, respectively.

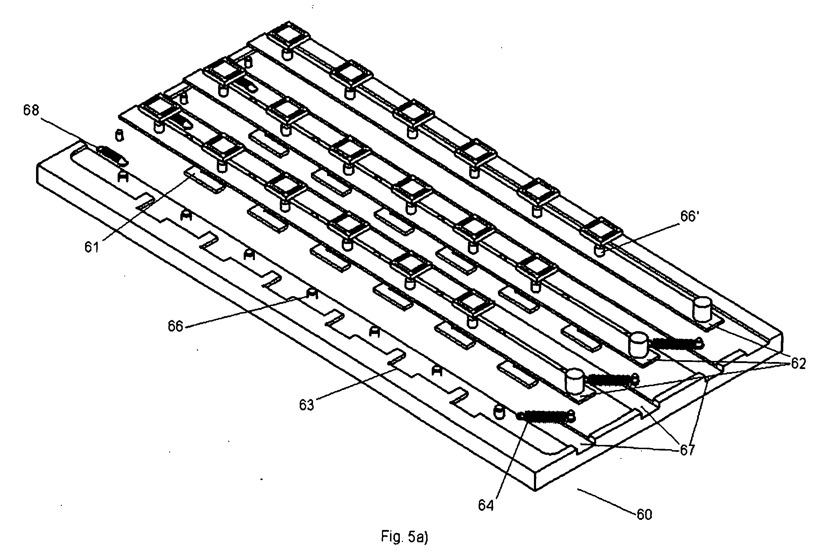

Another example of a carrier 1 not being part of the invention is illustrated in Figures 5a to 5c wherein clamping of the electronic components 11 is also facilitated by means of bands. Figures 5a to 5c show a plate 60 comprising pockets or seats 61 for accommodating and securing the electronic components 11 and three actuators 62. Whereas three actuators 62 are shown, the number of actuators may be chosen differently. The plate 60 comprises cut-outs 43 at the lower edge for accepting the lower edges of the electronic components 11 of the lowest row of electronic components 11 to be carried by the carrier. In the clamped state of the carrier the electronic components 11 of the lowest row of electronic components 11 can be secured by means of the cut-outs 63. Similar to the example shown in Figures 4a to 4d there are provided springs 64, bands 65 and deflection elements 66 and 66'. However, one group of defection elements 66 is formed on the plate 60, whereas the other group of deflection elements 66' is formed as part of the actuators 62. Figure 6 is also an illustration of securing an electronic component for this example but one the deflection elements 35 shown in Figure 6 is formed on the plate 60 whereas the other one is formed on the bar actuator 62 in this example.

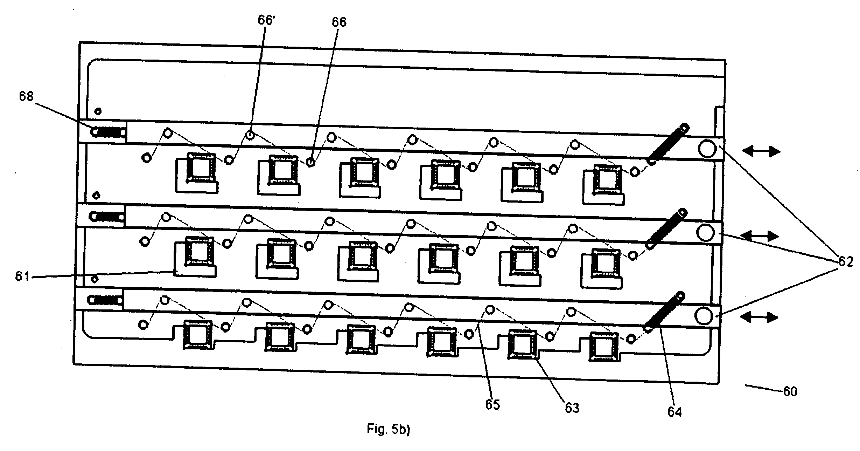

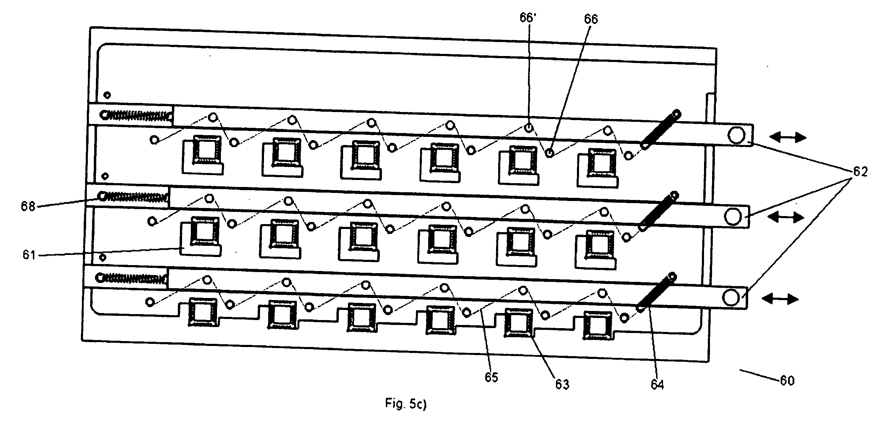

The actuators 62 are formed are bars that are moveable in bearings 67 of the plate 60. It is to be noted that the actuators 62 can be operated by corresponding openers associated with each of the actuators (not shown in Figures 5a to 5c) or one single opener. Whereas in the previous example (see Figures 4a to 4d) one actuator, namely the clamping plate 31, was moved for transition from the clamped state of the carrier to the opened state of the carrier and vice versa, in the example shown in Figures 5 to 5c, three actuators 62 are moved.

In the clamped state the actuators 62 are almost completely inserted in the bearings 67 (i.e. almost up to the left-hand ends of the bearings 67 illustrated in Figure 5b). In this position, the deflection elements 66' that are formed on or integrally with the actuators 62 cause tensioning of the bands 65 such that the electronic components 11 are secured against dead stops of the pockets 61 of the plate 60 and the cut-outs 63, respectively (see Figure 5b). The actuators 62 may be pushed and secured against some springs 68 provided in the bearings 67, for example.

By operation of one or more openers the actuators 62 may be released and pushed outwardly of the bearings 67 by the springs 68 in order to cause transition of the carrier to the opened state (see Figure 5c). In the opened state the bands 65 no longer contact the electronic components 11 and the electronic components 11 can be removed.

In the all of the above-described embodiments and comparative examples a small number (one or more) of actuators is employed for transition of the carrier between the clamped and opened state and, moreover, a small number (one or more) of openers is needed for operating the actuators. The actuators are realized as plates or bars that can easily and inexpensively be manufactures and promise long lifetimes. Whereas mainly actuators are shown that are moveable in the same direction, all of the above-described exampled may be supplemented by additional actuators, for example, comprising additional clamping plates or linear guiding elements or bars, that are moveable in another direction, for example, in a direction perpendicular to the one of the shown embodiments and examples.

## Claims

1. Carrier for carrying a plurality of electronic components, comprising
a base plate comprising a plurality of seats or openings each configured to accommodate one of the plurality of electronic components (11); and
a first actuator (21) moveable in a first direction with respect to the base plate for securing more than one of the plurality of electronic components (11) in the seats or openings in a clamped state of the carrier, **characterised in that** the base plate comprises an elongated element (50) formed on the base plate and comprising dead stops (10) for receiving edges of the electronic components (11) in the clamped state and the first actuator (21) comprises a plurality of clamping elements (16) arranged along a straight line and configured for securing the electronic components (11) in the clamped state.

2. The carrier according to claim 1, wherein the first actuator (21) comprises a linear guiding element (22) and the plurality of clamping elements (16) are formed on both sides of the linear guiding element (22), in particular, in the form of wedges.

3. The carrier according to claim 2, wherein the plurality of clamping elements (16) are grouped in pairs and one clamping element of a pair of the plurality of clamping elements (16) is arranged on one side of a linear guiding element (22) and the other clamping element of the pair of the plurality of clamping elements (16) is arranged on the other side of the linear guiding element (22) symmetrically to the linear guiding element (22).

4. The carrier according to claim 2 or 3, wherein each of the plurality of clamping elements (16) is connected with a corresponding spring (23) being part of or connected with the linear guiding element (22) and/or the plurality of clamping elements (16) are made of a resilient material.

5. The carrier according to one of the claims 2 to 4, further comprising a second actuator (21) comprising another linear guiding element (22) and the plurality of clamping elements (16) formed on both sides of the other linear guiding element (22), in particular, in the form of wedges.

## Patentansprüche

1. Träger zum Tragen einer Mehrzahl an elektronischen Komponenten, mit
einer Grundplatte mit einer Mehrzahl an Aufnahmen oder Öffnungen, von denen jede dazu ausgebildet ist, eine der Mehrzahl an elektronischen Komponenten (11) aufzunehmen; und
einen ersten Aktuator (21), der in eine erste Richtung hinsichtlich der Grundplatte zum Sichern von mehr als einer der Mehrzahl an elektronischen Komponenten (11) in den Aufnahmen oder Öffnungen in einem geklemmten Zustand des Trägers beweglich ist,
**dadurch gekennzeichnet, dass**
die Grundplatte eine längliches Element (50) umfasst, das auf der Grundplatte ausgebildet ist und Anschläge zum Aufnehmen von Kanten der elektronischen Komponenten (11) in dem geklemmten Zustand umfasst, und der erste Aktuator (21) eine Mehrzahl an Klemmelementen (16) umfasst, die entlang einer geraden Linie angeordnet sind und dazu ausgebildet sind, die elektronischen Komponenten (11) in dem geklemmten Zustand zu sichern.

2. Der Träger gemäß Anspruch 1, in dem der erste Aktuator (21) ein lineares Führungselement (22) umfasst, und die Mehrzahl an Klemmelementen (16), insbesondere in Form von Keilen, auf beiden Seiten des linearen Führungselements (22) angeordnet ist.

3. Der Träger gemäß Anspruch 2, in dem die Mehrzahl an Klemmelementen (16) in Paaren gruppiert ist und ein Klemmelement eines Paars der Mehrzahl an Klemmelementen (16) auf einer Seite eines linearen Führungselements (22) angeordnet ist und das andere Klemmelement des Paars der Mehrzahl an Klemmelementen (16) auf der anderen Seite des linearen Führungselements (22) symmetrisch zu dem linearen Führungselement (22) angeordnet ist.

4. Der Träger gemäß Anspruch 2 oder 3, in dem jedes der Mehrzahl an Klemmelementen (16) mit einer entsprechenden Feder (23), die Teil des linearen Führungselements (22) ist oder mit diesem verbunden ist, verbunden ist und/oder die Mehrzahl an Klemmelementen (16) aus einem elastischen Material hergestellt ist.

5. Der Träger gemäß einem der Ansprüche 2 bis 4, weiterhin mit einem zweiten Aktuator (21), der ein weiteres lineares Führungselement (22) und die Mehrzahl an Klemmelementen (16) auf beiden Seiten des weiteren linearen Führungselements (22) umfasst.

## Revendications

1. Support destiné à supporter une pluralité de composants électroniques, comprenant
une plaque de base comprenant une pluralité d'assises ou d'ouvertures, chacune étant configurée pour recevoir un composant de la pluralité de composants électroniques (11) ; et
un premier dispositif d'actionnement (21) pouvant être déplacé dans une première direction par rapport à la plaque de base pour fixer plusieurs composants de la pluralité de composants électroniques (11) dans les assises ou ouvertures dans un état serré du support, **caractérisé en ce que** la plaque de base comprend un élément allongé (50) formé sur la plaque de base et comprenant des butées fixes (10) pour recevoir les bords des composants électroniques (11) dans l'état serré et le premier dispositif d'actionnement (21) comprend une pluralité d'éléments de serrage (16) agencés le long d'une ligne droite et configurés pour fixer les composants électroniques (11) dans l'état serré.

2. Support selon la revendication 1, dans lequel le premier dispositif d'actionnement (21) comprend un élément de guidage linéaire (22) et les éléments de la pluralité d'éléments de serrage (16) sont formés sur les deux côtés de l'élément de guidage linéaire (22), en particulier sous la forme de coins.

3. Support selon la revendication 2, dans lequel les éléments de la pluralité d'éléments de serrage (16) sont regroupés par paires et un élément de serrage d'une paire d'éléments de la pluralité d'éléments de serrage (16) est agencé sur un côté d'un élément de guidage linéaire (22) et l'autre élément de serrage de la paire de la pluralité d'éléments de serrage (16) est agencé sur l'autre côté de l'élément de guidage linéaire (22) de façon symétrique par rapport à l'élément de guidage linéaire (22).

4. Support selon la revendication 2 ou 3, dans lequel chaque élément de la pluralité d'éléments de serrage (16) est relié au moyen d'un ressort correspondant (23) faisant partie de l'élément de guidage linéaire (22) ou relié à celui-ci et/ou les éléments de la pluralité d'éléments de serrage (16) sont faits d'un matériau élastique.

5. Support selon l'une des revendications 2 à 4, comprenant en outre un second dispositif d'actionnement (21) comprenant un autre élément de guidage linéaire (22) et les éléments de la pluralité d'éléments de serrage (16) formés sur les deux côtés de l'autre élément de guidage linéaire (22), en particulier, sous la forme de coins.
